# EUROPEAN PATENT APPLICATION

(11) **EP 4 535 357 A2**
(43) Date of publication of application: **09.04.2025**
(21) Application number: 24204776.9
(22) Date of filing: 04.10.2024
(51) Int. Cl.: G11C 7/22, G11C 29/02, G11C 29/50

(54) **SIMULTANEOUS BIDIRECTIONAL SIGNALING IN THROUGH-SILICON VIAS**

(30) Priority: 06.10.2023 US 202363543023 P
(71) Applicant: Marvell Asia Pte Ltd, Singapore 369522 (SG)
(72) Inventor: Baldwin, Zachary, Burlington, Vermont, 05401 (US)
(74) Representative: Grünecker Patent- und Rechtsanwälte PartG mbB

(57) **Abstract**

A signal transmitter transmits a signal onto the bidirectional transmission medium of the TSV. A boost circuit is available to supplement the signal as needed. Calibration circuitry periodically activates, at an interval of time, a signal driver of the signal transmitter to transmit a test signal on the bidirectional transmission medium of the TSV. The calibration circuitry then compares a level of the test signal to a range, with different levels within the range corresponding to different logic levels. If the level of the test signal is outside an expected range, a boost circuit is activated to bring the level of the test signal into the expected range.

## Description

### Cross Reference to Related Applications

This disclosure claims the benefit of copending, commonly-assigned United States Provisional Patent Application No. 63/543,023, filed October 6, 2023, which is hereby incorporated by reference herein in its entirety.

### Field of Use

This disclosure relates to a multi-layer electronic device for data transfer and storage employing ultra-fast and ultra-short range physical layer transceivers (PHYs) for transmitting and receiving signals between device layers. More particularly, this disclosure relates to maintaining signal integrity in bidirectional signaling in chip-to-chip signaling paths, such as through-silicon vias (TSVs).

### Background

The background description provided herein is for the purpose of generally presenting the context of the disclosure. Work of the inventors hereof, to the extent the work is described in this background section, as well as aspects of the description that may not otherwise qualify as prior art at the time of filing, are neither expressly nor impliedly admitted to be prior art against the subject matter of the present disclosure.

In traditional circuit structures, PHYs are either integrated into a die or are laterally disposed in a package with respect to other components. The placement of PHYs in these structures requires a high level of signal processing to ensure the integrity of a signal passed to the PHY for receipt by a remote device. By stacking a chip or chiplet on which a PHY is disposed on top of a main chip, the distance from components on the main chip to the PHY is shortened significantly. In stacked-die circuit structures, signals may be transmitted between components on different dies in the stacked-die structure. To facilitate such transmissions, structures known as through-silicon vias (TSVs) provide communication paths from one die to another. Conventional stacked-die structures pass data between stacked dies, chips, or chiplets using a conventional PHY connected to a synchronous data bus. Trace matching variation limits the data speed of these conventional PHYs to 3.2Gbps. The data rate may also be limited because the PHY will have to use a lower Nyquist frequency to reduce insertion loss. Without equalization circuitry, the PHY must be run at a lower data rate to communicate over the channel. Accordingly, conventional stacked-die circuit structures are currently used only in applications where faster data rates are not critical and such conventional structures would not be suitable for use with components such as a serializer/deserializer (SERDES) or in artificial intelligence or machine learning circuitry.

Environmental factors such as temperature, humidity, etc., may affect the operation of a signal driver or a component of the signal driver. A signal driver may contain two field effect transistors (FET) as its data driver elements. A P-type FET, for example, may be responsible for generating a signal representing a logic one while an N-type FET may be responsible for generating a signal associated with a logic zero. Changes in environmental and operating conditions can change the output signal level of each FET, resulting in a mismatch in output levels between the two FETs. Such a mismatch can result in the signal level falling outside the range of one logic level and into the range of a different logic level, causing the receiver of the signal to receive incorrect or corrupted data.

### Summary

Systems, methods, and apparatus are described herein for transmitting and receiving signals on a bidirectional transmission medium of a through-silicon via (TSV). A signal transmitter transmits a signal onto the bidirectional transmission medium of the TSV. A boost circuit is available to supplement the signal as needed. Calibration circuitry periodically activates, at an interval of time, a signal driver of the signal transmitter to transmit a test signal on the bidirectional transmission medium of the TSV. The calibration circuitry then compares a level of the test signal to a range, with different levels within the range corresponding to different logic levels. If the level of the test signal is outside an expected range, a boost circuit is activated to bring the level of the test signal into the expected range.

In some implementations, the signal driver includes a P-type transistor configured to transmit a signal at a first level corresponding to a first logic level, and an N-type transistor configured to transmit a signal at a second level corresponding to a second logic level different from the first logic level. The calibration circuitry may then include a first comparator configured to compare a first level of the first signal to a first range, and a second comparator configured to compare a second level of the second signal to a second range. The boost circuit may also include a P-type transistor configured to transmit a signal at a first level corresponding to a first logic level, and an N-type transistor configured to transmit a signal at a second level corresponding to a second logic level.

In some implementations, the calibration circuitry compares the test signal to the range using a comparator. The comparator may be a sample and hold comparator.

In some implementations, the interval of time at which the calibration process is periodically performed is a multiple of a duration of a clock cycle. Each interval may coincide with a start of a clock cycle. The interval of time may, in some implementations, be calibrated such at the calibration circuitry activates the signal driver at the start of every clock cycle.

In some implementations, the calibration circuitry may deactivate the signal driver after an amount of time less than the duration of the clock cycle. This allows the signal transmitter to transmit data onto the bidirectional transmission medium of the TSV during at least a portion of the clock cycle.

### Brief Description of the Drawings

Further features of the disclosure, its nature and various advantages, will be apparent upon consideration of the following detailed description, taken in conjunction with the accompanying drawings, in which like reference characters refer to like parts throughout, and in which:
FIG. 1 is a schematic representation of an illustrative stacked-die circuit structure with TSVs and respective transceivers at each end of each TSV for transmitting and receiving signals through each respective TSV, in accordance with some implementations of the subject matter of this disclosure;
FIG. 2 is a cross-sectional representation of the illustrative stacked-die circuit structure of FIG. 1;
FIG. 3 is a cross-sectional representation of an area of an illustrative stacked-die structure containing a TSV through which bidirectional signaling occurs between layers of the stacked-die circuit structure, in accordance with some implementations of the subject matter of this disclosure;
FIG. 4 is a circuit diagram showing illustrative circuitry for calibrating signal levels of a signal driver to ensure accurate data transmission over a TSV, in accordance with some implementations of the subject matter of this disclosure;
FIG. 5 is a circuit diagram showing illustrative circuitry for comparing a signal level to a range to recover binary data from a received signal, in accordance with some implementations of the subject matter of this disclosure;
FIG. 6 depicts a series of eyes representing a clock signal and signal levels present on a TSV during different phases of the clock signal at a time when no data is being transmitted on the TSV, in accordance with some implementations of the subject matter of this disclosure; and
FIG. 7 is a flow diagram representing an illustrative process for calibrating a signal driver, in accordance with some implementations of the subject matter of this disclosure.

### Detailed Description

As noted above, stacked-die circuit structures are generally limited to applications in which high speed data transmissions are not required. Accordingly, components of a stacked-die circuit structure that rely on communication between the stacked dies do not include devices that require high-speed data transfer, such as PHYs or SERDES, network switches, storage controllers, AI processors, and the like. Instead, these devices are laterally disposed on the same chip, chiplet, or package and require a high level of signal processing to ensure signal integrity due to the long distance that the signal must travel across the chip, chiplet, or package.

The subject matter of this disclosure enables maintenance of bidirectional signal integrity in chip-to-chip signaling paths. While the subject matter of this disclosure described below focuses on the example of a TSV, it is nonetheless applicable to other chip-to-chip signaling paths such as in 3D face-to-face configurations in which two integrate circuitry chips communicate with each other only though hybrid bond interconnects. This disclosure also allows for compensation of any mismatch in signal levels between components responsible for transmitting different logic level signals onto the TSV, thereby ensuring that the correct data values are received at the other end of the TSV. This allows the subject matter of this disclosure to be used in the context of data transfer, storage, and processing, as well as other contexts in which the transmission and receipt of large quantities of data to and from remote devices is required. A transceiver at one end of a TSV transmits and receives signals concurrently. The signal present on the transmission medium of the TSV is therefore a combination of the transmitted and received signals. To ensure that any signal transmitted or received on the TSV is accurate, the signal levels representing different logic levels must be calibrated to within an acceptable range.

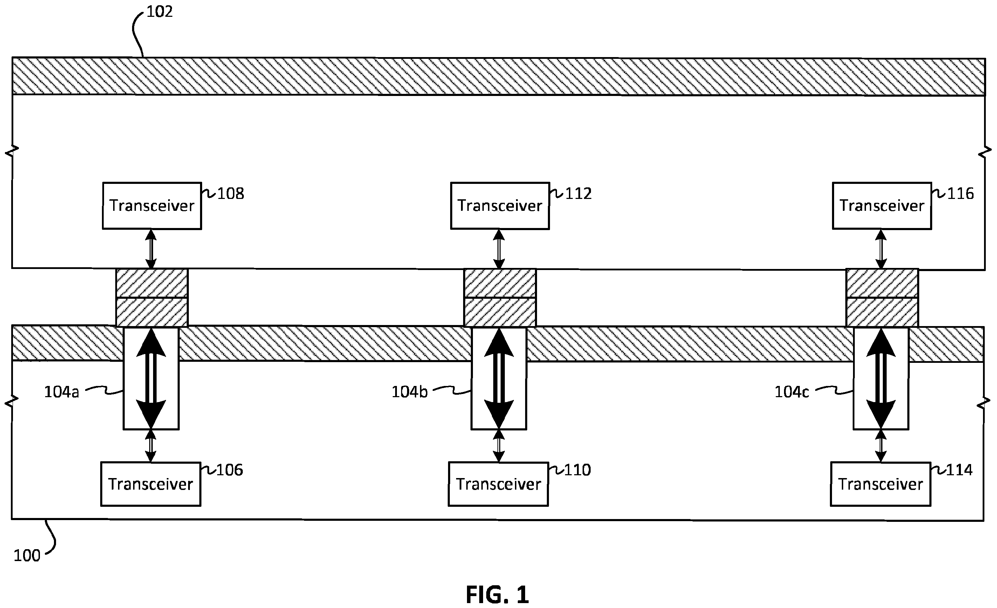

The subject matter of this disclosure may be better understood by reference to FIGS. 1-7.

FIG. 1 is a schematic representation of an illustrative stacked-die circuit structure with TSVs through which signals may be transmitted between the dies, in accordance with some implementations of the subject matter of this disclosure. Die 100 and die 102 form a stacked-die circuit structure. TSVs 104a-104c are formed in die 100 and communicatively connect die 100 and die 102. Transceivers 106, 110, and 114 transmit signals onto respective TSVs 104a, 104b, and104c from die 100 to die 102 while transceivers 108, 112, and 116 transmit signals onto respective TSVs 104a, 104b, and 104c from die 102 to die 100. As the TSV provides a bidirectional transmission path between die 100 and die 102, any transceiver disposed on either die 100 or die 102 may transmit signals onto its respective TSV at any time. Accordingly, any signal transmitted onto a TSV may overlap, at least partially, with a signal transmitted in the opposing direction.

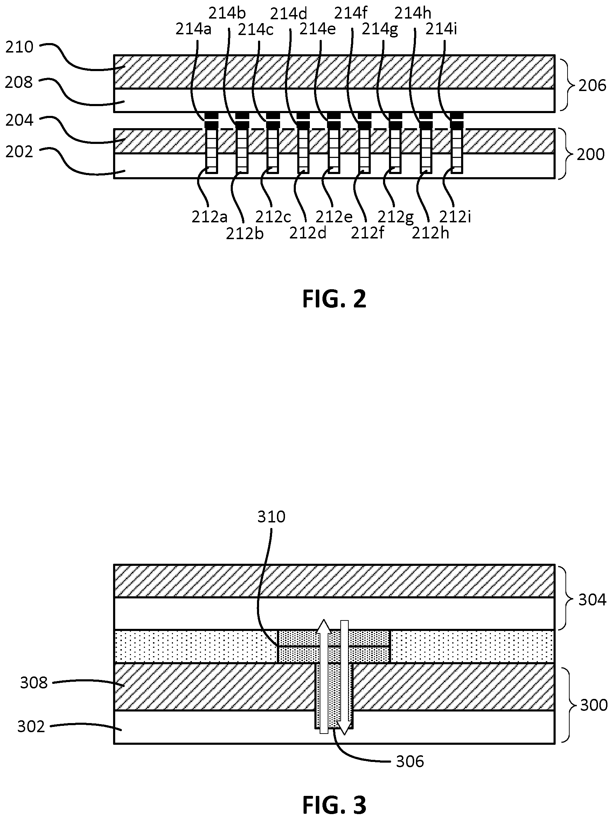

FIG. 2 is a cross-sectional representation of an illustrative stacked-die circuit structure with TSVs, in accordance with some implementations of the subject matter of this disclosure. The stacked-die circuit structure of FIG. 2 is formed of die 200 containing a wiring layer 202 deposited on a device silicon layer 204 and die 206 containing a wiring layer 208 deposited on a device silicon layer 210. TSVs 212a-212i (of which TSVs 104a-104c of FIG. 1 are an illustrative subset) provide signaling pathways between die 200 and die 206. At the interface between the TSVs and die 206 are hybrid bonds 214a-214i through which signals from die 200 are communicated to die 206 and through which signals from die 206 are transmitted onto a transmission medium of each corresponding TSV. Hybrid bonds, also known as direct bond interconnects (DBI), are a permanent bond that combines a dielectric bond with an embedded metal to form an interconnection between two stacked dies. For example, hybrid bonding interconnection point may be fabricated on a first die by depositing a dielectric (e.g., a silicon oxide) over metallic (e.g., copper) pillars or other contact structures. The surface of the die may then be planed to remove any of the dielectric material that covered the contacts during deposition and create a flat surface for mating with another die. A second die with hybrid bonding interconnection points can then be stacked on the first die such that the hybrid bonding interconnection points are aligned. The two dies are then bonded together (e.g., using heat) such that both the metallic contact structures and the dielectric material are fused together. In one example implementation, die 200 is a memory device (e.g., SRAM) and die 206 is a system-on-a-chip (SOC) device. In another example, die 200 is a PHY and die 206 is a SERDES device. In some implementations, the transmission medium is a solid conductor, such as a copper wire formed in a via. However, other types of transmission media may be possible. These stacking and bonding techniques may also be applicable to stacks of more than two dies. For example, a stack of three dies may be stacked and bonded in this manner, so long as the die in the middle has interconnection points on both its top and bottom surfaces.

FIG. 3 is a cross-sectional representation of a TSV through which bidirectional signaling occurs between layers of a stacked-die circuit structure, in accordance with some implementations of the subject matter of this disclosure. Die 300 has a wiring layer 302 which may communicate with devices on other dies of the stacked-die circuit structure (e.g., die 304). TSV 306 begins in wiring layer 302 of die 300 and extends through device silicon layer 308 of die 300. A hybrid bond 310 communicatively couples TSV 306 with die 304, completing a signaling pathway between die 300 an die 304.

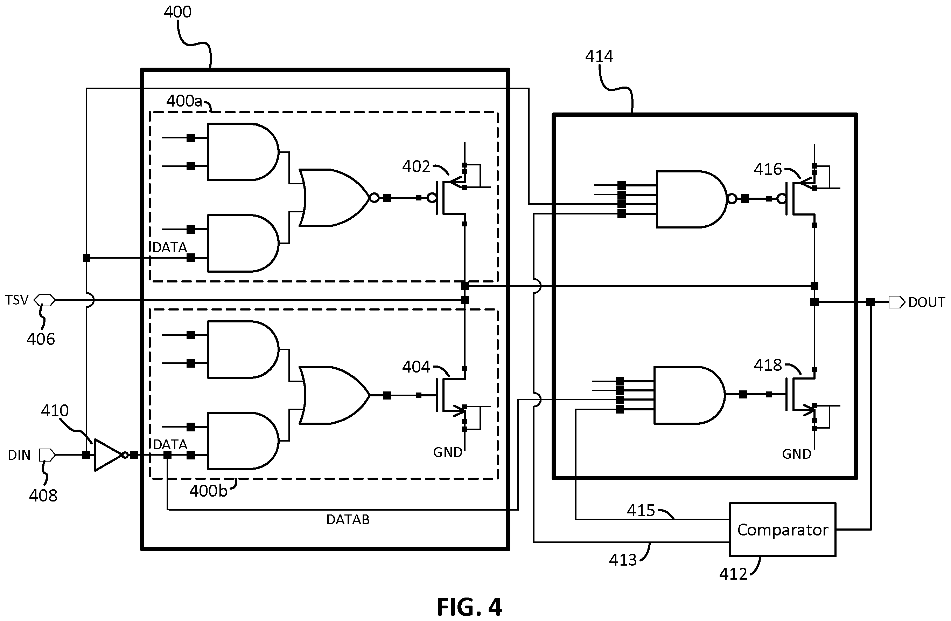

FIG. 4 is a circuit diagram showing illustrative circuitry for calibrating signal levels of a signal driver to ensure accurate data transmission over a TSV, in accordance with some implementations of the subject matter of this disclosure. Signal driver elements 400a and 400b (collectively, driver elements 400) are used to transmit data onto a TSV. For example, driver element 400a may be responsible for transmitting a logic one onto the TSV by pulling the output signal of the signal driver to a first signal level associated with a logic one (e.g., a more positive voltage level). Driver element 400b may similarly be responsible for transmitting a logic zero onto the TSV by pulling the output signal of the signal drive to a second signal level associated with a logic zero (e.g., a more negative voltage level). This may be accomplished using switches, such as FETs 402 and 404. Activation of each FET causes the output signal to be pulled in the corresponding direction, thereby transmitting the associated binary value into TSV 406. In some implementations, the driver elements may be embedded, at least in part, on one or both of the device layers of each die in the interconnect structure (e.g., dies 200 and 206).

Data originating from, or passing through, the device layer of at least one die is received at connection 408 and provided to driver element 400a. The data is also passed through inverter 410 before being provided to driver element 400b. In this manner, each driver element is activated for different logic levels. When concurrent signals are transmitted in opposing directions on the TSV, the TSV signal level will be approximately halfway between the signal level associated with a logic zero and the signal level associated with a logic one when one signal contains a zero and the other signal contains a one. For example, at a time when one signal is at 700mV, corresponding to a logic one and the opposing signal is at 50mV, corresponding to a logic zero, the voltage of the signal will be 375mV. In another example, the voltage corresponding to a logic one may be 500mV and the voltage corresponding to a logic zero may be 100mV, resulting in a signal at 300mV. In yet another example, the voltage corresponding to a logic one may be 500mV while a logic zero corresponds to ground (i.e., 0mV) or, in some cases, slightly above 0mV (e.g., 5mV) because ground may not be exactly 0mV. This results in a test signal voltage of 250mV. However, if there is a mismatch in the output level or the amount by which one driver element switch, e.g. FET 402, pulls the signal in a positive direction and the output level or amount by which the other driver element switch, e.g., FET 404, pulls the signal in a negative direction, then signal present on the TSV may fall outside a threshold range when opposing signals transmit different values.

To compensate for any mismatch in output levels, driver elements 400 are periodically activated together and the resulting signal compared to a signal level range using comparator 412. When both driver elements are activated simultaneously with properly matched signal driver elements, the signal level should be halfway between the signal levels of each logic level. For example, if the signal level for a logic zero is 50mV and the signal level of a logic one is 700mV, the test signal generated by activating both signal drivers should be 375mV when the signal driver elements are properly matched. To account for minor deviations, the transceiver may be configured to read any signal below 375mV as a logic zero and any signal above 375mV as a logic one. In some implementations, other ranges based on threshold deviations from the expected signal levels for each logic level may be used.

If the signal driver elements are mismatched in their output levels, the test signal will not fall exactly between the levels of each logic level (e.g., 375mV). The test signal is compared, using comparator 412, to the logic value ranges to determine whether the test signal is at the midpoint between logic levels. If the signal level of the test signal is too close to the signal level of a logic zero, one of boost drivers 416 and 418 (collectively, boost drivers 414) is activated to supplement the lower-performing signal driver element and adjust the signal level toward the midpoint. Similarly, if the signal level of the test signal is too close to the signal level of a logic one, one of boost drivers 414 is activated to supplement the lower-performing signal driver element and adjust the signal level toward the midpoint. The boost drivers 414 activated during this calibration phase continue to be activated when their corresponding signal driver elements are activated to transmit a signal onto the bidirectional transmission medium of the TSV until the next calibration phase occurs.

Comparator 412 may be a sample and hold comparator. Comparator 412 samples the signal present on the TSV when both driver elements are activated. A reference voltage corresponding to the expected signal level when both driver elements are activated and properly matched is also provided to comparator 412. The signal present on the TSV is then compared to the reference voltage. If the signal level does not match the reference voltage, or is not within a threshold range of the reference voltage, then comparator 412 asserts a boost enable signal (first boost enable signal 413 or second boost enable signal 415) to the whichever boost driver is needed to bring the signal level to within a threshold range of the reference voltage.

In one example, it may be determined during a first calibration phase that a boost driver is needed to supplement the logic one signal driver. When the calibration phase ends and the signal transmission phase begins, the boost driver is activated whenever the logic one signal driver is activated in order to successfully transmit a logic one. The boost driver will continue to be activated in this manner until a second calibration phase determines whether it is still needed, or if the output power of the boost driver needs to be adjusted.

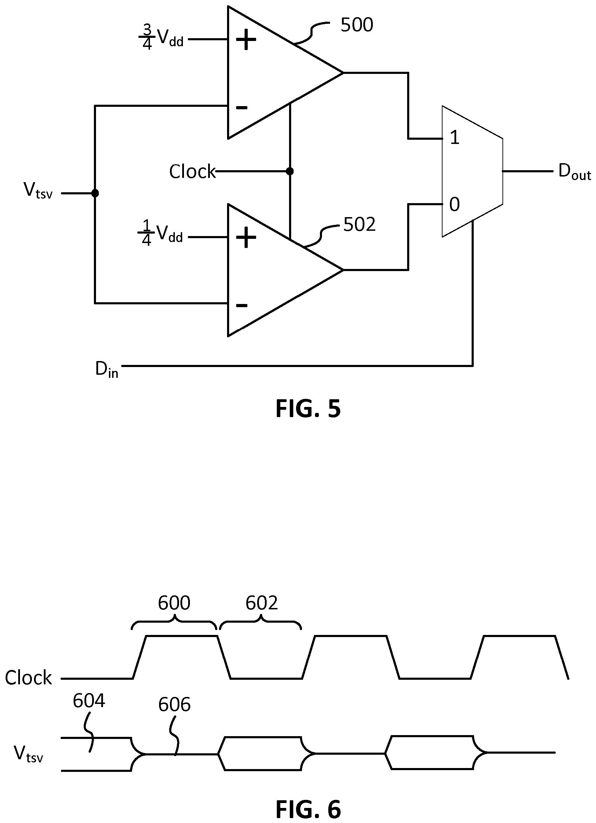

FIG. 5 is a circuit diagram showing illustrative circuitry for comparing a signal level to a range to recover binary data from a received signal, in accordance with some implementations of the subject matter of this disclosure. The received signal may be driven by the circuitry depicted FIG. 4. Two separate comparators 500 and 502 are used to determine whether the signal level on the TSV is in a range corresponding to a logic one or a logic zero. This creates a window comparator, with signals at or below one quarter of the maximum signal level indicating that both dies are transmitting a logic zero and signals at or above three quarters of the maximum signal level indicating that both dies are transmitting a logic one. Signal levels between one quarter of the maximum signal level and three quarters of the maximum signal level indicate that the two dies are transmitting opposite logical values (i.e., one die transmitting a logic one while the other die is transmitting a logic zero). To recover the received data in that case, the logical value transmitted by the die receiving the signal can be subtracted from the received signal.

FIG. 6 depicts a series of eyes representing a clock signal and signal levels present on a TSV during different phases of the clock signal at a time when no data is being transmitted on the TSV, in accordance with some implementations of the subject matter of this disclosure. First portion 600 of a clock cycle may be used for signal calibration, leaving second portion 602 of the clock cycle for data transfer. If the calibration is performed at every clock cycle, this would effectively result in half the maximum data rate that would be possible without performing calibration. To avoid such a drastic reduction in the data rate, the calibration may not be performed at every clock cycle but rather at some time interval longer than a single clock cycle.

When not performing calibration, and when no data is being transmitted, the signal 604 present on the TSV may include a high signal and a low signal generated by the driver elements in an idle state. Alternatively, the signal channel may remain undriven, with no signals present on the TSV. During portion 600 of the clock cycle, both driver elements are activated at the signal 606 present on the TSV is a mid-level signal between the high signal level and the low signal level. If the output signal level the driver elements is properly matched, mid-level signal 606 should be halfway between the high signal level and the low signal level. If the mid-level signal is outside the expected range, the corresponding boost element may be activated to compensate and bring the mid-level signal back into the expected range. During portion 602 of the clock cycle, the driver elements return to their idle state if no data is to be transmitted. If data is to be transmitted, the driver elements are activated to transmit the data, with one driver element being active when a logic zero is transmitted and the other drive element being active when a logic one is transmitted. During portion 602 of the clock cycle, the boost elements may also be activated as needed based on the outcome of the calibration process performed during portion 600 of the clock cycle.

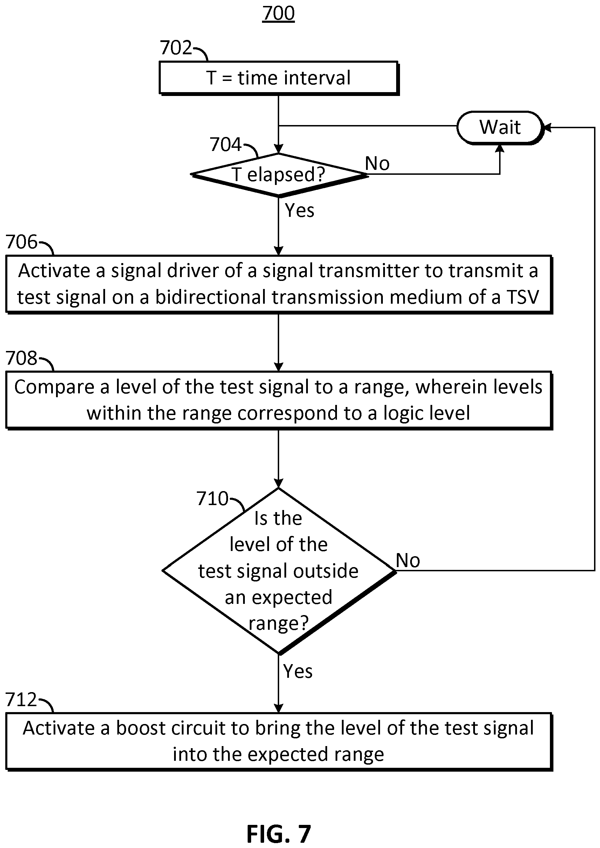

FIG. 7 is a flow diagram representing an illustrative process for calibrating a signal driver, in accordance with some implementations of the subject matter of this disclosure. At 702, calibration circuitry initializes or retrieves a value T representing a time interval at which calibration is to occur. This time interval may be the duration of a clock cycle, meaning that calibration will occur at every clock cycle, or some multiple of the duration of the clock cycle. At 704, the calibration circuitry determines whether the interval has elapsed. If not ("No" at 704), the calibration circuitry waits.

If the time interval has elapsed ("Yes" at 704), then, at 706, the calibration circuitry activates a signal driver of a signal transmitter to transmit a test signal on a bidirectional transmission medium of a TSV. Transmission of the test signal may be accomplished by activating a signal driver element responsible to transmitting a logic zero and simultaneously activating a second signal driver element responsible for transmitting a logic one. The resulting test signal should, therefore, have a signal level halfway between the signal level of a logic zero and the signal level of a logic one.

At 708, the calibration circuitry compares a level of the test signal to a range, wherein levels within the range correspond to a logic level. The level may be a voltage level or a current level. For example, a voltage level of 50mV may correspond to a logic zero and a voltage level of 700mV may correspond to a logic one. To account for minor changes in output levels, a threshold deviation, such as 100mv, may be permitted. Thus, any voltage level between 50mV and 150mV may be considered a logic zero and any voltage level between 600mV and 700mV may be considered a logic zero. Alternatively, any voltage level at or below 150mV may be considered a logic zero and any voltage level at or above 600mV may be considered a logic one. In another example, the threshold may be up one quarter of the difference between the voltage level of a logic zero and the voltage level of a logic one. If a logic zero corresponds to 50mV and a logic one corresponds to 700mv, one quarter of the different between the two logic levels is 162.5mV. Accordingly, any voltage level at or below 212.5mV may be considered a logic zero and any voltage level at or above 537.5mV may be considered a logic one. The calibration circuitry may compare the voltage level of the test signal to one or more of these thresholds to determine if the voltage level of the signal is outside an expected range. In some implementations, the calibration circuitry may determine whether the voltage level of the test signal is above the threshold level of a logic zero (e.g., 212.5mV) and below the threshold level of a logic one (e.g., 537.5mV).

At 710, the calibration circuitry determines whether the level of the test signal is outside an expected range. For example, the expected range may be above the threshold level of a logic zero and below the threshold level of a logic one (e.g., between 212.5mV and 537.5mV). If the level of the test signal is within the expected range ("No" at 710), then the calibration circuitry waits for the next calibration cycle.

If the calibration circuitry determines that the level of the test signal is outside the expected range ("Yes" at 710), then, at 712, the calibration circuitry activates a boost circuit to bring the level of the test signal into the expected range. For example, if the test signal is within the threshold of a logic zero (e.g., below 212.5mV), a boost driver configured to raise the voltage level of the test signal is activated. Similarly, if the test signal is within the threshold of a logic one (e.g., above 537.5mV), a boost driver configured to lower the voltage level of the test signal is activated. The output power of an activated boost driver may be variable and controlled by the calibration circuitry in order to bring the test signal level into the expected range without overshooting.

Thus it is seen that methods and systems for high-speed data transfer and storage using ultra-short range PHYs to perform bidirectional signaling in TSVs have been provided. This allows for reduced power requirements and increases available area on each die of a stacked-die circuit structure. By obviating the need to include complex signal processing and/or signal compensation circuitry, TSVs may be packed more densely on each die of the stacked-die circuit structure.

As used herein and in the claims which follow, the construction "one of A and B" shall mean "A or B."

It is noted that the foregoing is only illustrative of the principles of the invention, and that the invention can be practiced by other than the described embodiments, which are presented for purposes of illustration and not of limitation, and the present invention is limited only by the claims which follow.

**The following is a list of further preferred embodiments of the invention:**
Embodiment 1. A transceiver for transmitting and receiving signals on a bidirectional transmission medium of a through-silicon via (TSV), comprising:
   a signal transmitter configured to transmit a signal onto the bidirectional transmission medium of the TSV;
   a boost circuit configured to supplement the signal; and
   calibration circuitry configured to:
   activate, at an interval of time, a signal driver of the signal transmitter to transmit a test signal on the bidirectional transmission medium of the TSV;
   compare a level of the test signal to a range, wherein levels within the range correspond to a logic level; and
   in response to determining, based on the comparing, that the level of the test signal is outside an expected range, activate a boost circuit to bring the level of the test signal into the expected range.
Embodiment 2. The transceiver of embodiment 1, wherein the signal driver of the signal transmitter comprises:
   a P-type transistor configured to transmit a signal at a first level corresponding to a first logic level; and
   an N-type transistor configured to transmit a signal at a second level corresponding to a second logic level different from the first logic level.
Embodiment 3. The transceiver of embodiment 2, wherein the calibration circuitry further comprises:
   a first comparator configured to compare a first level of the first signal to a first range; and
   a second comparator configured to compare a second level of the second signal to a second range.
Embodiment 4. The transceiver of embodiment 1, wherein the boost circuit comprises:
   a P-type transistor configured to transmit a signal at a first level corresponding to a first logic level; and
   an N-type transistor configured to transmit a signal at a second level corresponding to a second logic level.
Embodiment 5. The transceiver of embodiment 1, wherein the calibration circuitry further comprises a comparator, wherein the calibration circuitry configured to compare a level of the test signal to a range is configured to compare, using the comparator, a reference level to the level of the test signal.
Embodiment 6. The transceiver of embodiment 1, further comprising:
   a clock having a clock cycle duration,
   wherein the interval of time is a multiple of a duration of the clock cycle duration, and
   wherein a start of each interval coincides with a start of a respective clock cycle.
Embodiment 7. The transceiver of embodiment 6, wherein the interval of time is calibrated such that the calibration circuitry activates the signal driver of the signal transmitter at the start of every clock cycle.
Embodiment 8. The transceiver of embodiment 6, wherein the calibration circuitry is further configured to deactivate the signal driver of the signal transmitter after an amount of time less than the duration of the clock cycle such that the signal transmitter can transmit data onto the bidirectional transmission medium of the TSV during at least a portion of the clock cycle.
Embodiment 9. A method for simultaneous bidirectional transmission of data on a bidirectional transmission medium of a through-silicon via (TSV), the method comprising:
   activating, at an interval of time, a signal driver of a signal transmitter to transmit a test signal on the bidirectional transmission medium of the TSV;
   comparing a level of the test signal to a range, wherein levels within the range correspond to a logic level; and
   in response to determining, based on the comparing, that the level of the test signal is outside an expected range, activating a boost circuit to bring the level of the test signal into the expected range.
Embodiment 10. The method of embodiment 9, wherein activating the signal driver of the signal transmitter comprises:
   activating a P-type transistor of the signal driver to transmit a signal at a first level corresponding to a first logic level; and
   activating an N-type transistor of the signal driver to transmit a signal at a second level corresponding to a second logic level different from the first logic level.
Embodiment 11. The method of embodiment 10, wherein comparing a level of the test signal to a range comprises:
   comparing a first level of the first signal to a first range; and
   comparing a second level of the second signal to a second range.
Embodiment 12. The method of embodiment 9, wherein activating the boost circuit com prises:
   activating a P-type transistor of the boost circuitry to transmit a signal at a first level corresponding to a first logic level; and
   activating an N-type transistor of the boost circuit to transmit a signal at a second level corresponding to a second logic level.
Embodiment 13. The method of embodiment 9, further comprising:
   providing, to a comparator, the test signal,
   wherein comparing a level of the test signal to a range is performed using the comparator.
Embodiment 14. The method of embodiment 9, further comprising:
   receiving a clock signal having a clock cycle duration,
   wherein the interval of time is a multiple of a duration of the clock cycle, and wherein a start of each interval coincides with a start of a respective clock cycle.
Embodiment 15. The method of embodiment 14, further comprising setting the interval of time such that the calibration circuitry activates the signal driver of the signal transmitter at the start of every clock cycle.
Embodiment 16. The method of embodiment 14, further comprising deactivating the signal driver of the signal transmitter after an amount of time less than the duration of the clock cycle such that the signal transmitter can transmit data onto the bidirectional transmission medium of the TSV during at least a portion of the clock cycle.
Embodiment 17. Apparatus comprising:
   a host device comprising a first integrated circuit die and a second integrated circuit die stacked on the first integrated circuit die and communicatively coupled to the first integrated circuit die by a plurality of through-silicon vias (TSVs); and
   a transceiver for transmitting and receiving signals on a bidirectional transmission medium of a TSV disposed on at least one of the first integrated circuit die or the second integrated circuit die, comprising:
      a signal transmitter configured to transmit a signal onto the bidirectional transmission medium of the TSV;
      a boost circuit configured to supplement the signal; and
      calibration circuitry configured to:
         activate, at an interval of time, a signal driver of the signal transmitter to transmit a test signal on the bidirectional transmission medium of the TSV;
         compare a level of the test signal to a range, wherein levels within the range correspond to a logic level; and
         in response to determining, based on the comparing, that the level of the test signal is outside an expected range, activate the boost circuit to bring the level of the test signal into the expected range.
Embodiment 18. The apparatus of embodiment 17, wherein the signal driver of the signal transmitter comprises:
   a P-type transistor configured to transmit a signal at a first level corresponding to a first logic level; and
   an N-type transistor configured to transmit a signal at a second level corresponding to a second logic level different from the first logic level.
Embodiment 19. The apparatus of embodiment 18, wherein the calibration circuitry further comprises:
   a first comparator configured to compare a first level of the first signal to a first range; and
   a second comparator configured to compare a second level of the second signal to a second range.
Embodiment 20. The apparatus of embodiment 17, wherein the boost circuit comprises:
   a P-type transistor configured to transmit a signal at a first level corresponding to a first logic level; and
   an N-type transistor configured to transmit a signal at a second level corresponding to a second logic level.
Embodiment 21. A transceiver for transmitting and receiving signals on a bidirectional transmission medium of a through-silicon via (TSV), comprising:
   a first signal driver element configured to transmit a first logic level onto the bidirectional transmission medium of the TSV;
   a second signal driver element configured to transmit a second logic level different from the first logic level onto the bidirectional transmission medium of the TSV;
   a first boost element configured to supplement an output level of the first signal driver;
   a second boost element configured to supplement an output level of the second signal driver; and
   control circuitry configured to:
      determine whether the first logic level or the second logic level is to be transmitted on the bidirectional transmission medium of the TSV;
      in response to determining that the first logic level is to be transmitted:
         activate the first driver element; and
         in response to determining, during a calibration process, that the output level of the first signal driver requires supplementation, activate the first boost element; and
         in response to determining that the second logic level is to be transmitted:
            activate the second driver element; and
            in response to determining, during the calibration process, that the output level of the second driver element requires supplementation, activate the second boost element.
Embodiment 22. The transceiver of embodiment 21, wherein the control circuitry is further configured to:
   transmit at least one logic level onto the bidirectional transmission medium of the TSV during a first portion of a clock cycle; and
   perform the calibration process during a second portion of the clock cycle.

## Claims

1. transceiver for transmitting and receiving signals on a bidirectional transmission medium of a through-silicon via (TSV), comprising:
a signal transmitter configured to transmit a signal onto the bidirectional transmission medium of the TSV;
a boost circuit configured to supplement the signal; and
calibration circuitry configured to:
activate, at an interval of time, a signal driver of the signal transmitter to transmit a test signal on the bidirectional transmission medium of the TSV;
compare a level of the test signal to a range, wherein levels within the range correspond to a logic level; and
in response to determining, based on the comparing, that the level of the test signal is outside an expected range, activate a boost circuit to bring the level of the test signal into the expected range.

2. The transceiver of claim 1, wherein the signal driver of the signal transmitter comprises:
a P-type transistor configured to transmit a signal at a first level corresponding to a first logic level; and
an N-type transistor configured to transmit a signal at a second level corresponding to a second logic level different from the first logic level.

3. The transceiver of claim 2, wherein the calibration circuitry further comprises:
a first comparator configured to compare a first level of the first signal to a first range; and
a second comparator configured to compare a second level of the second signal to a second range.

4. The transceiver of one of claims 1 to 3, wherein the boost circuit comprises:
a P-type transistor configured to transmit a signal at a first level corresponding to a first logic level; and
an N-type transistor configured to transmit a signal at a second level corresponding to a second logic level, or
wherein the calibration circuitry further comprises a comparator, wherein the calibration circuitry configured to compare a level of the test signal to a range is configured to compare, using the comparator, a reference level to the level of the test signal.

5. The transceiver of one of claims 1 to 4, further comprising:
a clock having a clock cycle duration,
wherein the interval of time is a multiple of a duration of the clock cycle duration, and wherein a start of each interval coincides with a start of a respective clock cycle, and/or
wherein the interval of time is calibrated such that the calibration circuitry activates the signal driver of the signal transmitter at the start of every clock cycle, or
wherein the calibration circuitry is further configured to deactivate the signal driver of the signal transmitter after an amount of time less than the duration of the clock cycle such that the signal transmitter can transmit data onto the bidirectional transmission medium of the TSV during at least a portion of the clock cycle.

6. A method for simultaneous bidirectional transmission of data on a bidirectional transmission medium of a through-silicon via (TSV), the method comprising:
activating, at an interval of time, a signal driver of a signal transmitter to transmit a test signal on the bidirectional transmission medium of the TSV;
comparing a level of the test signal to a range, wherein levels within the range correspond to a logic level; and
in response to determining, based on the comparing, that the level of the test signal is outside an expected range, activating a boost circuit to bring the level of the test signal into the expected range.

7. The method of claim 6, wherein activating the signal driver of the signal transmitter com prises:
activating a P-type transistor of the signal driver to transmit a signal at a first level corresponding to a first logic level; and
activating an N-type transistor of the signal driver to transmit a signal at a second level corresponding to a second logic level different from the first logic level, and/or
wherein comparing a level of the test signal to a range comprises:
comparing a first level of the first signal to a first range; and
comparing a second level of the second signal to a second range.

8. The method of one of claims claim 6 or 7, wherein activating the boost circuit comprises:
activating a P-type transistor of the boost circuitry to transmit a signal at a first level corresponding to a first logic level; and
activating an N-type transistor of the boost circuit to transmit a signal at a second level corresponding to a second logic level.

9. The method of one of claims 6 to 8, further comprising:
providing, to a comparator, the test signal,
wherein comparing a level of the test signal to a range is performed using the comparator, or
further comprising:
receiving a clock signal having a clock cycle duration,
wherein the interval of time is a multiple of a duration of the clock cycle, and
wherein a start of each interval coincides with a start of a respective clock cycle, and/or
further comprising setting the interval of time such that the calibration circuitry activates the signal driver of the signal transmitter at the start of every clock cycle, or
further comprising deactivating the signal driver of the signal transmitter after an amount of time less than the duration of the clock cycle such that the signal transmitter can transmit data onto the bidirectional transmission medium of the TSV during at least a portion of the clock cycle.

10. Apparatus comprising:
a host device comprising a first integrated circuit die and a second integrated circuit die stacked on the first integrated circuit die and communicatively coupled to the first integrated circuit die by a plurality of through-silicon vias (TSVs); and
a transceiver for transmitting and receiving signals on a bidirectional transmission medium of a TSV disposed on at least one of the first integrated circuit die or the second integrated circuit die, comprising:
a signal transmitter configured to transmit a signal onto the bidirectional transmission medium of the TSV;
a boost circuit configured to supplement the signal; and
calibration circuitry configured to:
activate, at an interval of time, a signal driver of the signal transmitter to transmit a test signal on the bidirectional transmission medium of the TSV;
compare a level of the test signal to a range, wherein levels within the range correspond to a logic level; and
in response to determining, based on the comparing, that the level of the test signal is outside an expected range, activate the boost circuit to bring the level of the test signal into the expected range.

11. The apparatus of claim 10, wherein the signal driver of the signal transmitter comprises:
a P-type transistor configured to transmit a signal at a first level corresponding to a first logic level; and
an N-type transistor configured to transmit a signal at a second level corresponding to a second logic level different from the first logic level.

12. The apparatus of claim 11, wherein the calibration circuitry further comprises:
a first comparator configured to compare a first level of the first signal to a first range; and
a second comparator configured to compare a second level of the second signal to a second range.

13. The apparatus of one of claims 10 to 12, wherein the boost circuit comprises:
a P-type transistor configured to transmit a signal at a first level corresponding to a first logic level; and
an N-type transistor configured to transmit a signal at a second level corresponding to a second logic level.

14. A transceiver for transmitting and receiving signals on a bidirectional transmission medium of a through-silicon via (TSV), comprising:
a first signal driver element configured to transmit a first logic level onto the bidirectional transmission medium of the TSV;
a second signal driver element configured to transmit a second logic level different from the first logic level onto the bidirectional transmission medium of the TSV;
a first boost element configured to supplement an output level of the first signal driver;
a second boost element configured to supplement an output level of the second signal driver; and
control circuitry configured to:
determine whether the first logic level or the second logic level is to be transmitted on the bidirectional transmission medium of the TSV;
in response to determining that the first logic level is to be transmitted:
activate the first driver element; and
in response to determining, during a calibration process, that the output level of the first signal driver requires supplementation, activate the first boost element; and
in response to determining that the second logic level is to be transmitted:
activate the second driver element; and
in response to determining, during the calibration process, that the output level of the second driver element requires supplementation, activate the second boost element.

15. The transceiver of claim 14, wherein the control circuitry is further configured to:
transmit at least one logic level onto the bidirectional transmission medium of the TSV during a first portion of a clock cycle; and
perform the calibration process during a second portion of the clock cycle.
